# EUROPÄISCHE PATENTSCHRIFT

(11) **EP 0 989 565 B1**
(45) Veröffentlichungstag und Bekanntmachung des Hinweises auf die Patenterteilung: **21.08.2002**
(21) Anmeldenummer: 99118399.7
(22) Anmeldetag: 16.09.1999
(51) Int. Cl.: G11C 7/06, H01L 27/108, G11C 11/409, H01L 27/105

(54) **Integrierter Speicher**
Integrated memory device
Dispositif de mémoire intégrée

(30) Priorität: 18.09.1998 DE 19842852
(43) Veröffentlichungstag der Anmeldung: 29.03.2000
(73) Patentinhaber: Infineon Technologies AG, 81669 München (DE)
(72) Erfinder: Le, Thoai-Thai, 81737 München (DE); Lindolf, Jürgen, Dr., 86316 Friedberg (DE); Schneider, Helmut, 80993 München (DE)
(74) Vertreter: Reinhard - Skuhra - Weise & Partner

(56) Entgegenhaltungen:
- US-A- 4 653 023
- US-A- 5 132 931
- US-A- 5 251 168
- US-A- 5 394 354

## Beschreibung

Die Erfindung betrifft einen integrierten Speicher gemäß dem Oberbegriff des Anspruchs 1, wie aus der US-A-5,394,354 bekannt.

Die US-A-5,132,931 beschreibt einen integrierten Speicher, bei dem die Eingänge eimer Logikeinheit mit dem vom Wortleitungsdecoder abgewandten Ende je einer der Wortleitungen verbunden sind.

Die US-A-5,251,168 beschreibt die Verwendung von Endzellen zur Verbesserung der Haltezeit in Speichervorrichtungen.

In der US 4,807,193 A ist ein DRAM beschrieben, das Speicherzellen vom Ein-Transistor/ Ein-Kondensator-Typ aufweist. Aus einer der Speicherzellen auf eine Bitleitung ausgelesene Signale werden von einem Leseverstärker verstärkt. Dabei erfolgt eine Auswahl der Speicherzelle über eine Wortleitung, die mit einem Steueranschluß des Speicherzellentransistors verbunden ist. Damit der Leseverstärker die ausgelesenen Informationen rechtzeitig verstärkt, weist er einen Aktivierungseingang auf, dem ein Aktivierungssignal zugeführt wird, das abhängig vom Potential auf der Wortleitung ist. Auf diese Weise soll gewährleistet werden, daß der Leseverstärker erst aktiv wird, wenn das Potential der Wortleitung einen bestimmten Pegel erreicht hat, so daß davon ausgegangen werden kann, daß die Speicherzelle bereits über die Wortleitung ausgewählt worden ist. Die US 4,807,193 A bezieht sich auf einen Speicher mit nur einer Wortleitung.

Der Erfindung liegt die Aufgabe zugrunde, einen integrierten Speicher mit einer Vielzahl von Wortleitungen und Bitleitungen anzugeben, bei dem eine Aktivierung wenigstens einer Bewertereinheit zum Bewerten von aus den Speicherzellen auf die Bitleitungen ausgelesenen Informationen wenigstens für mehrere der Wortleitungen zeitoptimiert und mit geringem Hardwareaufwand erfolgt.

Diese Aufgabe wird mit einem integrierten Speicher gemäß Anspruch 1 gelöst. Vorteilhafte Aus- und Weiterbildungen der Erfindung sind Gegenstand abhängiger Ansprüche.

Der erfindungsgemäße integrierte Speicher weist Speicherzellen zum Speichern von Informationen auf, die in einem Zellenfeld in Kreuzungspunkten von Bitleitungen und Wortleitungen angeordnet sind. Ferner weist er einen Wortleitungsdecoder auf, über den die Wortleitungen adressierbar sind, und wenigstens eine Bewertereinheit zum Bewerten von aus den Speicherzellen auf die Bitleitungen ausgelesenen Informationen, die einen Aktivierungeingang aufweist. Desweiteren weist er eine Logikeinheit zur Ausführung einer Oder-Funktion auf mit Eingängen, die mit dem vom Wortleitungsdecoder abgewandten Ende je einer der Wortleitungen verbunden sind, und mit einem Ausgang, der mit dem Aktivierungseingang der Bewertereinheit verbunden ist.

Bei dem integrierten Speicher kann es sich um einen beliebigen Speicher handeln, der Bitleitungen und Wortleitungen aufweist sowie wenigstens eine entsprechende Bewertereinheit. Daher eignet sich die Erfindung sowohl für beschreibbare Speicher wie DRAMs, SRAMs, Flash-Speicher und EEPROMS als auch für Nur-Lese-Speicher (ROMs).

Da die Logikeinheit mit den vom Wortleitungsdecoder abgewandten Enden der Wortleitungen verbunden ist, wirkt sich eine Selektion einer bestimmten der Wortleitungen durch den Decoder und ein damit verbundener Potentialwechsel dieser Wortleitung erst dann auf die Eingänge der Logikeinheit aus, wenn die gesamte Wortleitung umgeladen worden ist. Die Ausbreitung des neuen Signalpegels auf der Wortleitung erfolgt ausgehend vom Decoder in Richtung des von ihm abgewandten Endes der Wortleitung. Das Verbinden der Logikeinheit mit den Enden der Wortleitungen hat daher den Vorteil, daß auch die vom Decoder am weitesten entfernteste der mit der Wortleitung verbundenen Speicherzellen sicher selektiert worden ist, wenn sich der Pegelwechsel der aktuell über den Decoder adressierten Wortleitung am Eingang der Logikeinheit auswirkt. Somit nimmt die Logikeinheit erst Einfluß auf den Aktivierungseingang der Bewertereinheit, wenn sich am vom Wortleitungsdecoder abgewandten Ende der jeweiligen Wortleitung ein Pegelwechsel bemerkbar macht. Die Erfindung hat weiterhin den Vorteil, daß für alle mit der Logikeinheit verbundenen Wortleitungen die Aktivierung der Bewertereinheit zeit-optimiert durchgeführt wird. Dies wird durch die Oder-Funktion der Logikeinheit gewährleistet. Für jede einzelne der mit der Logikeinheit verbundenen Wortleitungen wird die Bewertereinheit erst dann aktiviert, wenn am jeweiligen Eingang der Logikeinheit ein Pegelwechsel eingetreten ist.

Erfindungsgemäß ist der integrierte Speicher ein dynamischer Speicher (DRAM) vom Ein-Transistor/ Ein-Kondensator-Typ, dessen Speicherzellen je einen Speicherkondensator aufweisen, dessen erste Elektrode mit einem festen ersten Potential und dessen zweite Elektrode über einen Auswahltransistor mit einer der Bitleitungen verbunden ist. Ferner weist sein Zellenfeld an dessen Rand Endzellen auf, die im Gegensatz zu den Speicherzellen nicht dem Speichern von Informationen, sondern zur Optimierung eines Herstellprozesses der Speicherzellen dienen und die im wesentlichen wie die Speicherzellen gestaltet sind mit je einem Kondensator sowie einem Auswahltransistor. Dabei sind wenigstens ein Teil derjenigen Endzellen, die an einer vom Wortleitungsdecoder abgewandten Seite des Zellenfeldes angeordnet sind, Bestandteile der Logikeinheit. Nach einer Weiterbildung der Erfindung sind Steuereingänge der Auswahltransistoren dieser Endzellen die Eingänge der Logikeinheit. Dabei ist der vom Kondensator abgewandte Anschluß der Auswahltransistoren dieser Endzellen mit einer Leitung verbunden, die mit dem Ausgang der Logikeinheit verbunden ist, und der dem Auswahltransistor zugewandte Anschluß des Kondensators dieser Endzellen ist mit einem festen zweiten Potential verbunden.

Die Endzellen, die zur Prozeßoptimierung während der Herstellung der Speicherzellen dienen, begünstigen während der Herstellung die Erzeugung der unterschiedlichen Schichten, aus denen der integrierte Speicher hergestellt wird. beispielsweise können die Speicherkondensatoren der Speicherzellen Grabenkondensatoren sein. Zu ihrer Herstellung werden in einem Substrat Gräben erzeugt, in denen die Kondensatoren mit ihren Elektroden ausgebildet werden. Da diese Gräben zur Herstellung der Elektroden beziehungsweise zur Durchführung nachfolgender Herstellungsschritte mit verschiedenen Materialien gefüllt werden müssen, kommt es am Rande eines herzustellenden Speicherzellenfeldes mit Grabenkondensatoren beim Aufbringen dieser Schichten zu Unregelmäßigkeiten wie z.B. Erhebungen. Dies liegt daran, daß die Gräben des Speicherzellenfeldes eine größere Menge des Schichtmaterials aufnehmen, als die Bereiche neben dem Speicherzellenfeld, die keine Gräben aufweisen. Daher werden Endzellen, die üblicherweise keine elektrische Funktion haben, zusätzlich zu den Speicherzellen am Rande des Zellenfeldes erzeugt. Da die Endzellen im wesentlichen wie die Speicherzellen gestaltet sind, sind die Kondensatoren der Endzellen ebenfalls Grabenkondensatoren, wenn die Speicherkondensatoren der Speicherzellen Grabenkondensatoren sind. Durch die Endzellen am Rande des Speicherzellenfeldes ist dann gewährleistet, daß die erzeugten Schichten im Bereich der Speicherzellen, die sich innerhalb des Speicherzellenfeldes befinden, sehr gleichmäßig sind. Eine Beeinflussung der erzeugten Schichten durch den Übergang zwischen im Zellenfeld vorhandenen Grabenstrukturen und Bereichen ohne Gräben außerhalb des Speicherzellenfeldes erfolgt dann nur im Randbereich des Zellenfeldes, wo die Endzellen angeordnet sind. Die Speicherzellen bleiben davon unbeeinflußt.

Die beschriebene Weiterbildung der Erfindung hat den Vorteil, daß die üblicherweise keiner elektrischen Funktion dienenden Endzellen zur Realisierung der Logikeinheit verwendet werden. Damit entfallen entsprechende zusätzlich notwendige Komponenten, die ohne Verwendung der Endzellen zur Realisierung der Logikeinheit vorgesehen werden müßten. Daher ist der Platzbedarf der Logikeinheit relativ gering.

Die Erfindung wird im folgenden anhand der Figuren näher erläutert.

Es zeigen:
- Figur 1: ein Ausführungsbeispiel des integrierten Speichers,
- Figur 2: ein Speicherzellenfeld des integrierten Speichers aus Figur 1 mit Endzellen und Speicherzellen,
- Figur 3: ein Detail einer Logikeinheit aus Figur 1,
- Figur 4: ein Ausführungsbeispiel eines Speicherkondensators und
- Figur 5: eine alternative Ausführungsform der Logikeinheit.

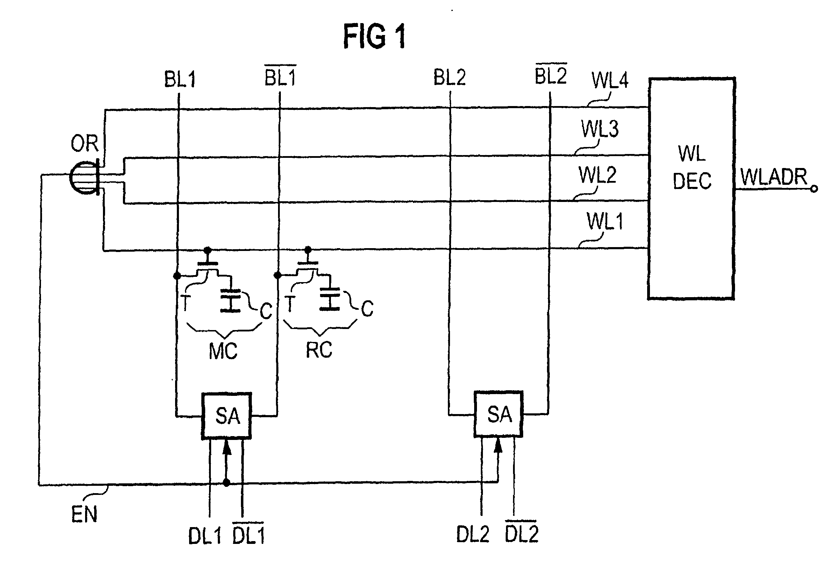

Figur 1 zeigt einen integrierten Speicher vom Typ DRAM mit einer Vielzahl von horizontal verlaufenden Wortleitungen WLi und einer Vielzahl von vertikal verlaufenden Bitleitungspaaren BLk, /BLk. Das DRAM weist Speicherzellen MC vom Ein-Transistor/ Ein-Kondensator-Typ auf. Zwischen den Bitleitungen BLk, /BLk und Masse weisen diese Speicherzellen MC einen Auswahltransistor T vom n-Kanal-Typ und einen Speicherkondensator C auf. Ein Steueranschluß des Auswahltransistors T ist mit einer der Wortleitungen WLi verbunden. Die Wortleitungen WLi sind mit Ausgängen eines Wortleitungsdecoders WLDEC verbunden. Diesem werden eingangsseitig Wortleitungsadressen WLADR zugeführt, über die die Wortleitungen WLi adressierbar sind. Obwohl reale Speicher eine große Anzahl von Wortleitungen und Bitleitungen aufweisen, sind zur Veranschaulichung in Figur 1 nur wenige dieser Leitungen dargestellt.

Die Bitleitungspaare BLk, /BLk sind mit Bewertereinheiten SA in Form von Leseverstärkern verbunden, die zum Bewerten, das heißt Verstärken, der aus den Speicherzellen MC auf die Bitleitungen ausgelesenen Informationen dienen. Die Leseverstärker SA geben diese Informationen verstärkt auf Datenleitungspaare DLk, /DLk weiter. Beim Speicher aus Figur 1 werden die ausgelesenen Informationen als Differenzsignal auf dem jeweiligen Bitleitungspaar BLk, /BLk dem Leseverstärker SA zugeführt, der auf dem entsprechenden Datenleitungspaar DLk, /DLk die verstärkte Information ebenfalls als Differenzsignal weitergibt. Wenn eine erste Bitleitung BL1 über einen (in Figur 1 nicht dargestellten) Bitleitungsdecoder adressiert wird, wird gleichzeitig die zugehörige zweite Bitleitung /BL1 des Bitleitungspaares aktiviert.Auf die erste Bitleitung BL1 wird der Inhalt einer Speicherzelle MC und auf die zweite Bitieitung /BL1 dieses Datenleitungspaares der Inhalt einer Referenzzelle RC ausgelesen. Der Leseverstärker SA verstärkt im aktivierten Zustand dieses Differenzsignal auf übliche Weise.

Beim DRAM aus Figur 1 weisen die Wortleitungen WLi ein niedriges Potential auf, sofern sie nicht über den Wortleitungsdecoder WLDEC adressiert sind. Wird eine der Wortleitungen WLi über den Wortleitungsdecoder WLDEC aktiviert, weist sie einen hohen Pegel auf, so daß die mit ihr verbundenen Auswahltransistoren T leitend geschaltet werden. Dabei breitet sich bei einer Aktivierung einer der Wortleitungen der hohe Pegel mit einer gewissen Laufzeit vom entsprechenden Ausgang des Wortleitungsdecoders WLDEC bis zum im linken Bereich der Figur 1 befindlichen, vom Wortleitungsdecoder abgewandten Ende der jeweiligen Wortleitung WLi aus.

Die vom Wortleitungsdecoder WLDEC abgewandten Enden der Wortleitungen WLi in Figur 1 sind mit Eingängen einer Logikeinheit in Form eines ODER-Gatters OR verbunden. Ein Ausgang des ODER-Gatters OR ist mit je einem Aktivierungseingang der Leseverstärker SA verbunden. Solange ein Aktivierungsignal EN, das das ODER-Gatter OR auf dieser Leitung erzeugt, einen niedrigen Pegel aufweist, sind die Leseverstärker SA deaktiviert und geben keine Information auf die Datenleitungen DLk, /DLk aus. Bei einem hohen Pegel des Aktivierungssignals EN sind die Leseverstärker SA aktiviert und üben ihre Verstärkerfunktion aus. Das Aktivierungssignal EN hat immer dann einen niedrigen Pegel, wenn keine der mit dem ODER-Gatter OR verbundenen Wortleitungen WLi durch den Wortleitungsdecoder WLDEC aktiviert worden ist. Sobald eine der Wortleitungen über den Wortleitungsdecoder WLDEC aktiviert worden ist und sich der hohe Signalpegel bis ans Ende dieser Wortleitung ausgebreitet hat, erzeugt das ODER-Gatter OR an seinem Ausgang ebenfalls einen hohen Pegel und aktivierte die mit ihm verbundenen Leseverstärker SA.

Da die Eingänge des ODER-Gatters OR in Figur 1 mit den vom Wortleitungsdecoder WLDEC abgewandten Enden der Wortleitungen WLi verbunden sind, werden die Leseverstärker SA über das Aktivierungssignal EN erst aktiviert, wenn auch die am weitesten vom Wortleitungsdecoder WLDEC entfernte Speicherzellen MC über ihre Auswahltransistoren T ausgewählt worden sind.

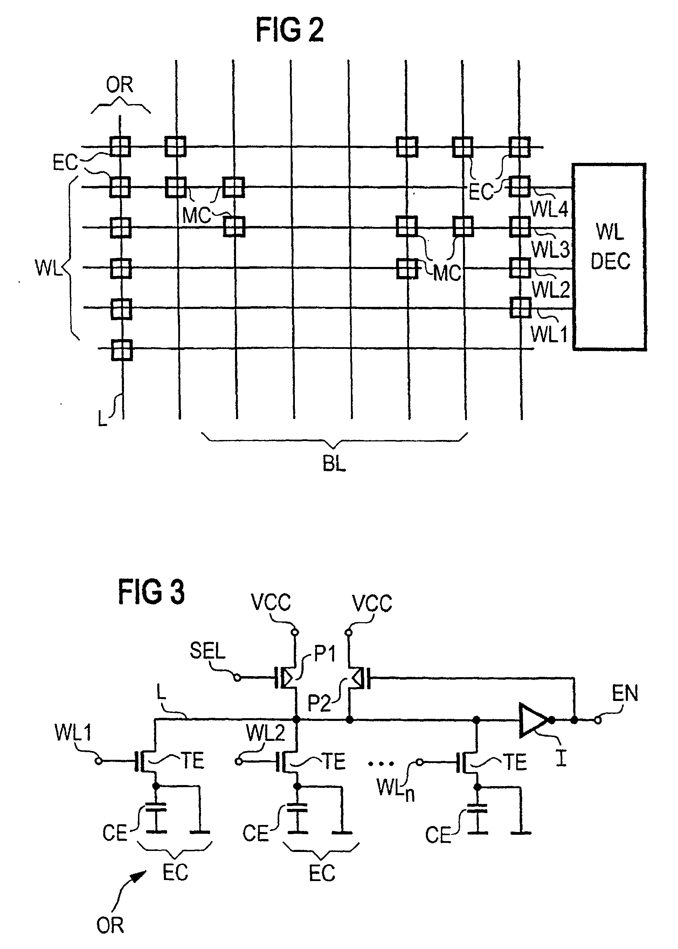

Figur 2 zeigt ein Ausführungsbeispiel eines Speicherzellenfeldes des DRAMs aus Figur 1 in einer topologischen Darstellung, die die örtliche Anordnung der Speicherzellen MC zeigt. Vertikal verlaufen wiederum die Bitleitungen BL und horizontal die Wortleitungen WL. Die Speicherzellen MC befinden sich in Kreuzungspunkten der Wortleitungen WL und Bitleitungen BL innerhalb des Speicherzellenfeldes. Der Rand des Speicherzellenfeldes wird dagegen durch eine Reihe von Endzellen EC gebildet, die die Speicherzellen MC umgeben. Die Endzellen EC sind im wesentlichen wie die Speicherzellen MC gestaltet und weisen daher ebenfalls einen Kondensator und einen Auswahltransistor auf.

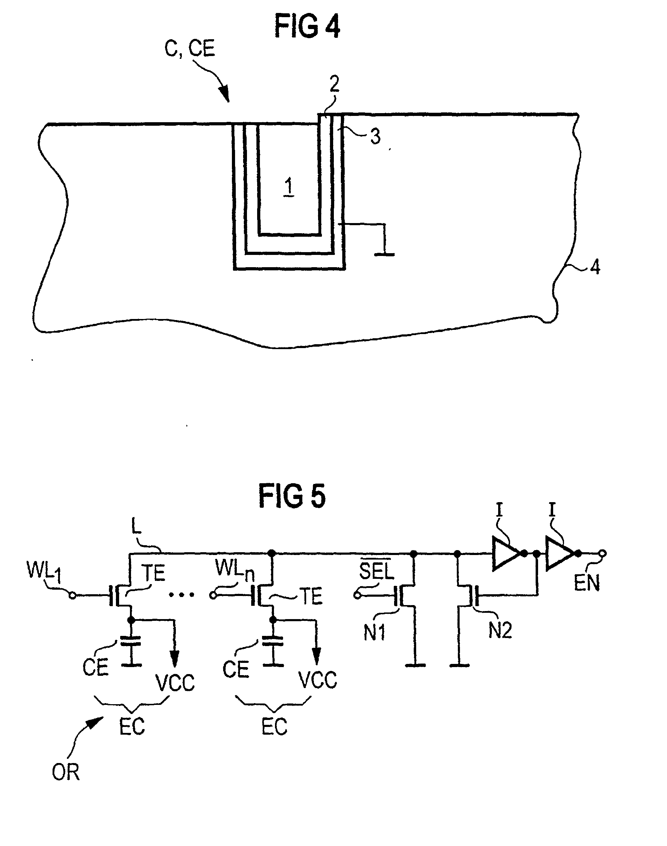

Im vorliegenden Fall sind die Kondensatoren C der Speicherzellen MC und die Kondensatoren CE der Endzellen EC jeweils Grabenkondensatoren der in Figur 4 dargestellten Art. Der Grabenkondensator C; CE der Speicherzellen MC beziehungsweise Endzellen EC weist in einem Substrat 4 des integrierten Speichers in einem darin erzeugten Graben eine erste Elektrode 3 auf, die mit Masse verbunden ist und eine zweite Elektrode 1, die mit dem zugehörigen Auswahltransistor T; TE verbunden ist. Zwischen den beiden Elektroden 1, 3 befindet sich eine Isolierungsschicht 2 als Dielektrikum.

Die Endzellen EC am Rande des Zellenfeldes in Figur 2 dienen dazu, während der Herstellung des integrierten Speichers eine möglichst gleichförmige Herstellung der Grabenkondensatoren der Speicherzellen MC zu gewährleisten. Da außerhalb des dargestellten Zellenfeldes Bereiche des integrierten Speichers angeordnet sind, die während seiner Herstellung keine Gräben aufweisen, kommt es während der Herstellung in einem Übergangsbereich zwischen den Bereichen mit Gräben und den Bereichen ohne Gräben zu einer Beeinflussung des Herstellprozesses der Grabenkondensatoren. Daher ist es günstig, die Speicherzellen MC durch das Vorsehen der Endzellen EC von den Bereichen außerhalb des Speicherzellenfeldes zu beabstanden. Unregelmäßigkeiten bei der Herstellung der Zellen wirken sich dann nur auf die Grabenkondensatoren der Endzellen EC und nicht auf diejenigen der Speicherzellen MC aus.

Üblicherweise dienen derartige Endzellen EC lediglich dem beschriebenen Zweck der Prozeßoptimierung während der Herstellung des Speichers. Sie dienen dann keinerlei elektrischen beziehungsweise logischen Funktion nach der Fertigstellung des Speichers. Bei diesem Ausführungsbeispiel der Erfindung jedoch werden die Endzellen EC, deren Auswahltransistoren TE mit einer Leitung L verbunden sind, die sich am vom Wortleitungsdecoder WLDEC entfernten Rand des Zellenfeldes befindet, zur Realisierung der Logikeinheit OR verwendet. Dies wird im folgenden anhand der Figur 3 erläutert.

Figur 3 zeigt die Endzellen EC mit ihrem Kondensator CE und ihrem Auswahltransistor TE, die mit der in Figur 2 eingezeichneten Leitung L verbunden sind. Die Steueranschlüsse der Auswahltransistoren TE der Endzellen EC sind ebenfalls mit einer der Wortleitungen WLi verbunden. Die Endzellen EC unterscheiden sich in ihrem Aufbau nur in einem Detail von den Speicherzellen MC: Die dem Auswahltransistor TE zugewandte Elektrode ihrer Kondensatoren CE ist mit Masse verbunden. Wird über den Wortleitungsdecoder WLDEC eine der Wortleitungen WLi adressiert und breitet sich der daraufhin einstellende hohe Pegel bis zum Ende der Wortleitung aus, wo sich die mit diesem Ende verbundene Endzelle EC befindet, wird deren Auswahltransistor TE leitend geschaltet, so daß die Leitung L auf Masse gezogen wird. Ein mit der Leitung L verbundener Inverter I erzeugt am Ausgang der in Figur 3 dargestellten Logikeinheit OR das Aktivierungssignal EN aus Figur 1.

Die Leitung L in Figur 3 wird über ein Auswahlsignal SEL vor der Aktivierung einer der Wortleitungen WLi, das heißt bei gesperrten Auswahltransistoren TE der Endzellen EC, auf einen hohen Pegel vorgeladen, so daß das Aktivierungssignal EN am Ausgang der Logikeinheit OR zunächst einen niedrigen Pegel aufweist. Dieses Vorladen erfolgt mittels eines ersten p-Kanal-Transistors P1, der mit seinem Hauptstrompfad zwischen einem positiven Versorgungspotential VCC und der Leitung L angeordnet ist. Sein Steueranschluß ist mit dem Auswahlsignal SEL verbunden. Ein mit seinem Hauptstrompfad parallel zum ersten p-Kanal-Transistor P1 angeordneter zweiter p-Kanal-Transistor P2 hat einen Steuereingang, der mit dem Ausgang der Logikeinheit OR verbunden ist. Der Inverter I und der zweite p-Kanal-Transistor P2 bilden eine Halteschaltung, die den Potentialzustand der Leitung L hält, nachdem der erste p-Kanal-Transistor P1 bereits wieder gesperrt worden ist.

Figur 5 zeigt eine alternative Verschaltung der Endzellen EC zur Ausbildung der Logikeinheit OR. Bei diesen ist die mit dem Auswahltransistor TE verbundene Elektrode des Speicherkondensators CE nicht mit Masse, sondern mit einem positiven Versorgungspotential VCC des Speichers verbunden. Zur Vorladung der Leitung L ist diese über einen ersten n-Kanal-Transistor N1 mit Masse verbunden, dessen Gate mit einem Steuersignal /SEL verbunden ist. Die Leitung L ist außerdem über zwei in Reihe geschaltete Inverter I mit dem Ausgang der Logikeinheit OR verbunden, an dem diese das Aktivierungssignal EN erzeugt. Die Leitung L ist über einen zweiten n-Kanal-Transistor N2 mit Masse verbunden, dessen Gate mit dem Ausgang des ersten Inverters I verbunden ist. Die in Figur 5 dargestellte Realisierung der Logikeinheit OR hat den Vorteil, daß der Leseverstärker SA erst dann über das Aktivierungssignal EN aktiviert wird, wenn der Auswahltransistor TE einer der Endzellen EC so weit leitend geschaltet ist, daß er das an ihm anliegende Versorgungspotential VCC mit der Leitung L verbindet, wodurch eine Schaltschwelle des ersten Inverters I überschritten wird. Erst wenn das Potential der mit der jeweiligen Endzelle EC verbundenen Wortleitung WLi weit genug angestiegen ist, kommt es zu einem Wechsel des Aktivierungssignals EN von einem niedrigen auf einen hohen Pegel. Da die Endzellen EC am Rand des Zellenfeldes, das heißt am Ende der jeweiligen Wortleitung WLi, angeordnet sind, ist sichergestellt, daß bei der positiven Flanke des Aktivierungssignals EN auch der Auswahltransistor T der ausgewählten Speicherzelle MC über diese Wortleitung weit genug aufgesteuert worden ist. Die Logikeinheit OR in Figur 5 bewirkt also im Vergleich zu derjenigen aus Figur 3 einen späteren Wechsel des Aktivierungssignals EN vom niedrigen auf den hohen Pegel.

## Patentansprüche

1. Integrierter Speicher
- mit Speicherzellen (MC) zum Speichern von Informationen, die in einem Zellenfeld in Kreuzungspunkten von Bitleitungen (BL) und Wortleitungen (WL) angeordnet sind,
- mit einem Wortleitungsdecoder (WLDEC), über den die Wortleitungen (WL) adressierbar sind,
- mit wenigstens einer Bewertereinheit (SA) zum Bewerten von aus den Speicherzellen (MC) auf die Bitleitungen (BL) ausgelesenen Informationen, die einen Aktivierungseingang aufweist,
- und mit einer Logikeinheit (OR) zur Ausführung einer ODER-Funktion mit Eingängen, die mit dem Ende je einer der Wortleitungen (WL) verbunden sind, und mit einem Ausgang, der mit dem Aktivierungseingang der Bewertereinheit (SA) verbunden ist,
**dadurch gekennzeichnet,**
**daß**
- die Eingänge der Logikeinheit (OR) mit dem vom Wortleitungsdecoder (WLDEC) abgewandten Ende je einer der Wortleitungen (WL) verbunden sind,
- er ein dynamischer Speicher ist, dessen Speicherzellen (MC) je einen Speicherkondensator (C) aufweisen, dessen erste Elektrode mit einem festen ersten Potential und dessen zweite Elektrode über einen Auswahltransistor (T) mit einer der Bitleitungen (BL) verbunden ist,
- **daß** sein Zellenfeld an seinem Rand Endzellen (EC) aufweist, die nicht dem Speichern von Informationen, sondern zur Optimierung eines Herstellprozesses der Speicherzellen (MC) dienen und die im wesentlichen wie die Speicherzellen (MC) gestaltet sind mit je einem Kondensator (CE) sowie einem Auswahltransistor (TE),
- und **daß** wenigstens ein Teil derjenigen Endzellen (EC), die an einer vom Wortleitungsdecoder (WLDEC) abgewandten Seite des Zellenfeldes angeordnet sind, Bestandteile der Logikeinheit (OR) sind.

2. Integrierter Speicher nach Anspruch 1,
bei dem die Steuereingänge der Auswahltransistoren (TE) derjenigen Endzellen (EC), die Bestandteile der Logikeinheit (OR) sind, die Eingänge der Logikeinheit (OR) sind,
- bei dem vom Kondensator (CE) abgewandte Anschluß der Auswahltransistoren (TE) dieser Endzellen (EC) mit einer Leitung (L) verbunden ist, die mit dem Ausgang der Logikeinheit (OR) verbunden ist,
- und bei dem der dem Auswahltransistor (TE) zugewandte Anschluß des Kondensators (CE) dieser Endzellen (EC) mit einem festen zweiten Potential verbunden ist.

3. Integrierter Speicher nach Anspruch 1 oder 2,
dessen Speicherkondensatoren (C) der Speicherzellen (MC) und dessen Kondensatoren (CE) der Endzellen (EC) Grabenkondensatoren sind.

4. Integrierter Speicher nach Anspruch 2 oder 3,
dessen erstes Potential (Masse) mit dem zweiten Potential übereinstimmt.

## Claims

1. Integrated memory
- having memory cells (MC) for storing information items, which are arranged in a cell array at crossover points of bit lines (BL) and word lines (WL),
- having a word line decoder (WLDEC), by means of which the word lines (WL) can be addressed,
- having at least one evaluation unit (SA) for evaluating information items read from the memory cells (MC) onto the bit lines (BL), which has an activation input,
- and having a logic unit (OR) for performing an OR function having inputs connected to the end of each of the word lines (WL) and having an output connected to the activation input of the evaluation unit (SA),
**characterized in that**
- the inputs of the logic unit (OR) are connected to that end of each of the word lines (WL) which is remote from the word line decoder (WLDEC),
- it is a dynamic memory whose memory cells (MC) each have a storage capacitor (C), whose first electrode is connected to a fixed first potential and whose second electrode is connected to one of the bit lines (BL) via a selection transistor (T),
- **in that** its cell array has end cells (EC) at its edge, which end cells do not serve for storing information items but rather for optimizing a process for fabricating the memory cells (MC) and are configured essentially like the memory cells (MC), in each case with a capacitor (CE) as well as a selection transistor (TE),
- and **in that** at least some of those end cells (EC) which are arranged on a side of the cell array which is remote from the word line decoder (WLDEC) are component parts of the logic unit (OR).

2. Integrated memory according to claim 1,
in which the control inputs of the selection transistors (TE) of those end cells (EC) which are component parts of the logic unit (OR) are the inputs of the logic unit (OR),
- in which that terminal of the selection transistors (TE) of these end cells (EC) which is remote from the capacitor (CE) is connected to a line (L) which is connected to the output of the logic unit (OR),
- and in which that terminal of the capacitor (CE) of these end cells (EC) which faces the selection transistor (TE) is connected to a fixed second potential.

3. Integrated memory according to Claim 1 or 2,
whose storage capacitors (C) of the memory cells (MC) and whose capacitors (CE) of the end cells (EC) are trench capacitors.

4. Integrated memory according to Claim 2 or 3,
whose first potential (earth) corresponds to the second potential.

## Revendications

1. Mémoire intégrée comprenant
- des cellules de mémoire (MC) pour mémoriser des informations qui sont disposées dans un champ de cellules aux points de croisement entre des lignes de bits (BL) et des lignes de mots (WL),
- un décodeur de lignes de mots (WLDEC) permettant d'adresser les lignes de mots (WL),
- au moins une unité d'évaluation (SA) pour évaluer des informations lues sur les lignes de bits (BL) à partir des cellules de mémoire (MC), et qui présente une entrée d'activation,
- et une unité logique (OR) pour exécuter une fonction OU avec des entrées qui sont reliées à l'extrémité de respectivement l'une des lignes de mots (WL), et avec une sortie qui est reliée à l'entrée d'activation de l'unité d'évaluation (SA),
**caractérisée en ce**
- **que** les entrées de l'unité logique (OR) sont reliées à l'extrémité de respectivement l'une des lignes de mots (WL) opposée au décodeur de lignes de mots (WLDEC),
- **qu'**elle est une mémoire dynamique dont les cellules de mémoire (MC) présentent respectivement un condensateur de mémoire (C) dont la première électrode est reliée à un premier potentiel fixe et dont la deuxième électrode est reliée à l'une des lignes de bits (BL) par l'intermédiaire d'un transistor de sélection (T),
- **que** son champ de cellules présente sur son bord des cellules d'extrémité (EC) qui ne servent pas à la mémorisation d'informations mais à l'optimisation d'un processus de fabrication des cellules de mémoire (MC), et qui pour l'essentiel sont configurées comme les cellules de mémoire (MC) comprenant chacune un condensateur (CE) et un transistor de sélection (TE),
- et **qu'**au moins une partie des cellules d'extrémité (EC) qui sont disposées sur une face du champ de cellules opposée au décodeur de ligne de mots (WLDEC), sont des éléments constitutifs de l'unité logique (OR).

2. Mémoire intégrée selon la revendication 1,
- les entrées de commande des transistors de sélection (TE) de celles des cellules d'extrémité (EC) qui sont des éléments constitutifs de l'unité logique (OR) étant les entrées de l'unité logique (OR),
- le port opposé au condensateur (CE) des transistors de sélection (TE) de ces cellules d'extrémité (EC) étant relié à une ligne (L) qui est reliée à la sortie de l'unité logique (OR),
- et le port du condensateur (CE) de ces cellules (EC) faisant face au transistor de sélection (TE) étant relié à un deuxième potentiel fixe.

3. Mémoire intégrée selon la revendication 1 ou 2, dont les condensateurs de mémoire (C) des cellules de mémoire (MC) et dont les condensateurs (CE) des cellules d'extrémité (EC) sont des condensateurs à tranchées.

4. Mémoire intégrée selon la revendication 2 ou 3, dont le premier potentiel (masse) concorde avec le deuxième potentiel.
